**Europäisches Patentamt**

**European Patent Office**

**Office européen des brevets**

(19)

(11) Veröffentlichungsnummer : **0 211 019**
**B1**

(12) EUROPÄISCHE PATENTSCHRIFT

(45) Veröffentlichungstag der Patentschrift :
05.04.89

(51) Int. Cl.⁴ : **H 05 K   5/06**

(21) Anmeldenummer : **86900739.3**

(22) Anmeldetag : **22.01.86**

(86) Internationale Anmeldenummer :
**PCT/DE 86/00019**

(87) Internationale Veröffentlichungsnummer :
**WO/8604768 (14.08.86 Gazette 86/18)**

(54) AUS WENIGSTENS ZWEI TEILEN BESTEHENDES GEHÄUSE.

(30) Priorität : 02.02.85 DE 3503558

(43) Veröffentlichungstag der Anmeldung :
25.02.87 Patentblatt 87/09

(45) Bekanntmachung des Hinweises auf die Patenterteilung : 05.04.89 Patentblatt 89/14

(84) Benannte Vertragsstaaten :
DE FR GB IT SE

(56) Entgegenhaltungen :
GB-A- 2 050 128
US-A- 3 308 412
US-A- 3 959 577
US-A- 4 223 177

(73) Patentinhaber : ROBERT BOSCH GMBH
Postfach 50
D-7000 Stuttgart 1 (DE)

(72) Erfinder : FRIES, Romuald
Im Kaiserfeld 7
D-7141 Hochdorf/Enz. (DE)

EP 0 211 019 B1

## Beschreibung

### Stand der Technik

Die Erfindung geht aus von einem Gehäuse nach der Gattung des Hauptanspruchs. Bei derartigen bekannten Gehäusen kann es vorkommen, daß durch die unterschiedliche Wärmedehnzahl und durch Temperaturänderungen bedingt, ein Spalt zwischen den beiden Gehäuseteilen entsteht, durch welchen Feuchtigkeit in den Hohlraum eindringt. Befinden sich in diesem beispielsweise elektrische Geräte, so kann es dadurch zu Funktionsstörungen kommen.

### Vorteile der Erfindung

Das erfindungsgemäße Gehäuse mit den kennzeichnenden Merkmalen des Hauptanspruchs hat demgegenüber den Vorteil, daß der Gehäusehohlraum nach außen hin stets einwandfrei abgedichtet ist, so daß keine Funktionsstörungen infolge Eindringen von Flüssigkeit auftritt.

Durch die in den Unteransprüchen aufgeführten Maßnahmen sind Weiterbildungen der im Hauptanspruch angegebenen Merkmale möglich.

### Zeichnung

Zwei Ausführungsbeispiele der Erfindung sind in der Zeichnung dargestellt und in der nachfolgenden Beschreibung näher erläutert. Sie zeigen in wesentlich vereinfachter Darstellung Längsschnitte durch Gehäuse.

### Beschreibung der Ausführungsbeispiele

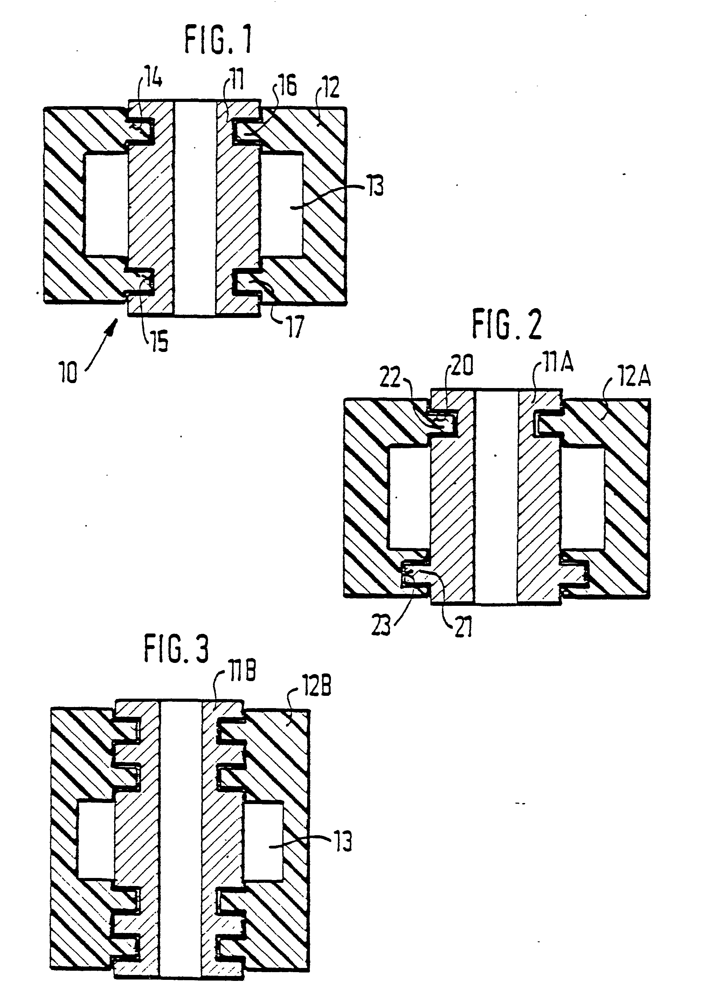

Das Gehäuse 10 nach Figur 1 besteht aus einem hohlzylindrischen Gehäuseinnenteil 11 und einem dieses umhüllenden, ebenfalls hohlzylindrischen Gehäuseaußenteil 12, die zusammen einen nicht dargestellte Geräte aufnehmenden Hohlraum 13 bilden. Das Gehäuseinnenteil 11 besteht aus einem relativ harten Werkstoff wie Metall, Keramik oder einem sehr harten Kunststoff, das Gehäuseaußenteil aus einem wesentlich weicheren Werkstoff, z. B. Thermoplast. Infolge dieser Werkstoffauswahl haben beide Teile eine sehr unterschiedliche Wärmedehnzahl.

Nahe den Stirnseiten des Gehäuseinnenteils 11 befinden sich an dessen Außenumfang zwei Ringnuten 14, 15 mit rechteckigem oder quadratischen Querschnitt, in welche am Innenumfang des Gehäuseaußenteils ausgebildete Ringwulste 16, 17 mit ebenfalls rechteckigem Querschnitt passend eingreifen. Das Gehäuseaußenteil 12 wird beispielsweise durch Spritzen hergestellt.

Durch die wesentlich größere Wärmedehnung des Werkstoffes des Gehäuseaußenteils 12 gegenüber demjenigen des Gehäuseinnenteils dehnt sich ersteres bei Erwärmung in seiner Längsrichtung stärker als das Gehäuseinnenteil 11, ebenfalls dehnen sich die Ringwulste 16, 17 stärker auch in axialer Richtung als die Ringnuten 14, 15.

Dadurch verspannen sich die Ringwulste gegenüber den Ringnuten derart, daß eine praktisch hermetische Abdichtung des Hohlraums 13 nach außen hin entsteht. Feuchtigkeit kann deshalb von außen her nicht in den Hohlraum 13 eindringen.

Selbstverständlich ist es auch möglich, das Gehäuseaußenteil aus dem härteren Werkstoff mit der geringeren Wärmedehnung herzustellen und dafür das Gehäuseinnenteil 11 aus dem weicheren Werkstoff mit der größeren Wärmedehnzahl. Der Effekt ist sinngemäß derselbe.

Das Ausführungsbeispiel nach Figur 2 unterscheidet sich von demjenigen nach Figur 1 lediglich dadurch, daß nun am Gehäuseinnenteil 11A nahe der einen Stirnseite wiederum eine Ringnut 20 ausgebildet ist, nahe der anderen Stirnseite ein Ringwulst 21, während am Gehäuseaußenteil 12A auf der einen Seite ein Ringwulst 22, auf der anderen Seite eine Ringnut 23 ausgebildet ist, wobei Ringwulst und Ringnut wieder passend ineinandergreifen. Die Werkstoffe sind wieder dieselben wie oben beschrieben, so daß sich im Prinzip ebenfalls wieder derselbe Dichteffekt den Ringnuten bzw. Ringwulsten infolge unterschiedlicher Wärmedehnung der beiden Werkstoffe ergibt. Die Querschnitte der Ringnuten und Ringwulste sind auch wieder rechteckig ausgebildet.

Beim Ausführungsbeispiel nach Figur 3 sind nahe der Stirnseite und am Außenumfang des Gehäuseinnenteils 11B zwei nahe beieinanderliegende, nicht weiter bezeichnete Ringnuten ausgebildet, am Innenumfang des Gehäuseaußenteils 12B zwei Ringwulste, die wieder passend in die Ringnuten tauchen. Ringwulste und Ringnuten haben wiederum rechteckigen bzw. quadratischen Querschnitt wie in den vorhergehenden Ausführungsbeispielen. Beim Ausführungsbeispiel nach Figur 2 verstärkt sich noch die Wirkung wie bei den zuvor geschilderten Ausführungsbeispielen.

Für jedes Ausführungsbeispiel gilt, daß es gleichgültig ist, ob das Gehäuseinnenteil oder das Gehäuseaußenteil aus dem Werkstoff mit der geringeren Härte bzw. der größeren Wärmeausdehnung besteht, oder ob die Ringnuten im Gehäuseinnenteil oder an Gehäuseaußenteil oder gemischt ausgebildet sind.

## Patentansprüche

1. Aus einem hohlzylindrischen Gehäuseinnenteil und einem dieses umhüllenden, ebenfalls hohlzylindrischen Gehäuseaußenteil bestehendes, einen Hohlraum bildendes Gehäuse, wobei die Teile aus stark unterschiedlich harten Werkstoffen mit unterschiedlicher Wärmedehnung bestehen, dadurch gekennzeichnet, daß beidseitig angrenzend an den Hohlraum (13) an einem der Teile (11, 12) mindestens eine im Querschnitt rechteckige Ringnut (14, 15) ausgebildet ist, in welche passend ein am anderen Teil ausgebildeter Ringwulst (16, 17) eintaucht.

2. Gehäuse nach Anspruch 1, dadurch gekennzeichnet, daß der härtere Werkstoff des einen Teils ein Metall, Keramik oder eine harter Kunststoff ist, der weichere Werkstoff des anderen Teils ein Thermoplast, welcher sich nicht mit dem härteren Werkstoff auf chemischem Wege verbindet.

3. Gehäuse nach Anspruch 1 und/oder 2, dadurch gekennzeichnet, daß das Gehäuseinnenteil (11) aus dem härteren Werkstoff besteht als das Gehäuseaußenteil (12).

4. Gehäuse nach einem der Ansprüche 1 bis 3, dadurch gekennzeichnet, daß beidseitig angrenzend an den Hohlraum (13) jeweils zwei nahe beieinanderliegende Ringnuten bzw. Ringwulste ausgebildet sind.

## Claims

1. Casing which comprises a hollow cylindrical casing inner part and a likewise hollow cylindrical casing outer part surrounding the former and forms a cavity, the parts consisting of materials having a widely different hardness and different thermal expansion, characterized in that at least one annular groove (14, 15) of rectangular cross-section is formed adjacent to the cavity (13) on both sides on one of the parts (11, 12), into which groove an annular bead (16, 17) formed on the other part fits. .

2. Casing according to Claim 1, characterized in that the harder material of the one part is a metal, ceramic or a hard plastic, and the softer material of the other part is a thermoplastic which does not enter into a chemical bond with the harder material.

3. Casing according to Claim 1 and/or 2, characterized in that the casing inner part (11) consists of the material which is harder than the casing outer part (12).

4. Casing according to one of Claims 1 to 3, characterized in that two closely adjoining annular grooves and annular beads are in each case formed adjacent to the cavity (13) on both sides.

## Revendications

1. Carter formant un espace creux, se composant d'une partie intérieure de carter cylindrique creuse et d'une partie extérieure de carter également cylindrique creuse, entourant celle-ci, les parties se composant à cette occasion de matériaux de duretés différentes, avec une dilatation thermique différente, caractérisé en ce qu'au moins une gorge annulaire (14, 15) de section rectangulaire est réalisée, produisant une délimitation des deux côtés sur l'espace creux (13) sur l'une des parties (11, 12), gorge dans laquelle plonge de manière ajustée un bourrelet annulaire (16, 17) formé sur l'autre partie.

2. Carter selon la revendication 1, caractérisé en ce que le matériau plus dur de l'une des parties est un métal, une céramique ou une matière plastique dure, que le matériau plus tendre de l'autre partie est un thermoplastique, qui ne se relie pas par voies chimiques au matériau plus dur.

3. Carter selon la revendication 1 et/ou 2, caractérisé en ce que par rapport à la partie extérieure de carter (12), la partie intérieure de carter (11) se compose du matériau plus dur.

4. Carter selon l'une des revendications 1 à 3, caractérisé en ce que chaque fois deux gorges annulaires voisines, respectivement deux bourrelets annulaires voisins, sont réalisés des deux côtés, de manière limitrophe sur l'espace creux (13).

FIG. 1

FIG. 2

FIG. 3